# EUROPEAN PATENT SPECIFICATION

(11) **EP 3 544 122 B1**
(45) Date of publication and mention of the grant of the patent: **26.10.2022**
(21) Application number: 18163066.6
(22) Date of filing: 21.03.2018
(51) Int. Cl.: H05K 1/11, H01R 12/79, H01R 12/77

(54) **CONNECTION ASSEMBLY WITH A THIN CONDUCTOR PIECE TO A THICK CONDUCTOR PIECE CONNECTED TO EACH OTHER, AND METHOD FOR CONNECTING SAID CONDUCTOR PIECES**
VERBINDUNGSANORDNUNG MIT EINEM DÜNNEN LEITERSTÜCKS UND EINEM DICKEN LEITERSTÜCK, DIE MITEINANDER VERBUNDEN SIND, UND VERFAHREN ZUM VERBINDEN DER LEITERSTÜCKE
ENSEMBLE DE CONNEXION COMPRENANT UNE PARTIE CONDUCTRICE MINCE ET UNE PARTIE CONDUCTRICE ÉPAISSE CONNECTÉES L'UNE À L'AUTRE, ET MÉTHODE DE CONNEXION DESDITES PARTIES CONDUCTRICES

(43) Date of publication of application: 25.09.2019
(73) Proprietor: TE Connectivity Germany GmbH, 64625 Bensheim (DE)
(72) Inventor: Do, Tran-Son, 69207 Sandhausen (DE)
(74) Representative: Grünecker Patent- und Rechtsanwälte PartG mbB

(56) References cited:
- EP-A1- 2 658 036
- DE-U1- 29 712 206
- US-A- 3 980 367
- US-A1- 2008 233 793

## Description

The invention relates to a connection assembly for electrically connecting at least one thin conductor piece to a thick conductor piece, in particular for a battery management system. The invention further relates to a method for connecting at least one thin conductor piece with at least one thick conductor piece.

Connecting thin conductor pieces with thick conductor pieces can be a challenging task. Known ways of providing such connections, for example by means of screw joints, bear the risk that the thin conductor piece may get damaged by said screw. Further, the reliability of the connection may be insufficient. Other means, such as soldering or welding bear the risk that the high temperature may melt and damage the thin conductor piece. Finally, if the conductors are made from different materials, such as aluminum and copper, the difficulty of forming a reliable electrical connection between the conductors is further increased. It is known from DE 297 12 206 U1, which is considered as disclosing the preamble of each of the independent claims 1 and 13, to provide a rail with a through hole, to insert two cylindrical bolts two opposing sides into the through hole and to connect cable lugs to the cylindrical bolts using a screw connection. From US 3,980,367 A, it is known to stack a plurality of printed circuit boards, insert a bolt into a trough hole of the stack and to let solder flow between the bolt and the boards.

It is therefore an object of the invention to provide a connection assembly and a method which provide a safe and reliable electrical connection between the at least one thin conductor piece and a thick conductor piece.

This object is achieved with a connection assembly according to independent claim 1, and a method according to independent claim 13.

The solution according to the invention solves at least one of the above-mentioned problems. By pressing the thin conductor piece against the thick conductor piece provides a reliable electrical connection between the two conductor pieces. The solution also provides a reliable mechanical connection between the conductor pieces. However, the focus lies on the electrical connection. Further, methods such as screwing, soldering or welding can be omitted such that the risk of damaging the thin conductor piece is decreased and the reliability of the connection is increased. Finally, the invention allows for a fast and cost-efficient assembly of connections.

The press-fit element may in particular generate a radial force directed to the thick conductor piece, in particular against the inner wall of the receptacle. Thereby, the radial force is directed radially from a direction which is parallel to an insertion direction of the press-fit element into the receptacle. In an assembled state, the protrusion of the thin conductor piece is held in place by a press-fit connection provided by the press-fit element. The invention is in particular beneficial if the two conductor pieces are made from different materials. In particular, one of the conductor pieces may be made from aluminum or from an alloy containing mostly aluminum, and the other conductor piece may be made from copper or an alloy containing mostly copper. The at least one thin conductor piece may in particular be a thin film or foil conductor, whereas the thick conductor piece may be a massive piece such as a plate or metal-sheet.

In the following, further improvements of the invention are described. The additional improvements may be combined independently of each other, depending on whether a particular advantage of a particular improvement is needed in a specific application. It should be noted that the method according to the invention may in particular be performed in order to form a connection assembly according to the invention. Consequently, the improvements and detail described with respect to the connection assembly also apply for the method and vice versa.

According to the invention, the press-fit element preferably has an overall shape of a disc, a ring, or a pill. A disc shape, i.e. flat shape, wherein the thickness of the disc is smaller than its diameter, firstly saves material and secondly may result in a press-fit element that is, in the assembled state, mostly inserted into the receptacle. The disc shape, in particular in contrast to a rod- or bolt-shape, prevents large portions of the press-fit element from protruding out of the receptacle in the assembled state. This may reduce the risk of damage to the connection assembly.

The press-fit element may have a thickness measured along a insertion direction, which is preferably between one and two times a thickness of the thick conductor piece. However, smaller or larger thicknesses are also possible.

In particular in the case of a press-fit element with an overall circular cross-section, the press-fit element preferably exerts a radial force along its whole circumference.

Just by way of example, a disc-shaped press-fit element may be provided with a hole which is preferably in its center, thereby forming a ring shape. The ring-shaped press-fit element may have increased flexibility compared to a similarly formed press-fit element without the hole. The hole is preferably a through hole. The hole can be used to facilitate insertion into the receptacle. For example, an insertion tool which is formed complementary to the press-fit element and which has a protrusion for insertion into the hole can be used to align the press-fit element with the receptacle and pressing the former into the letter. Further, the hole could be used for inserting other elements such as fixation means.

The at least one receptacle in the thick conductor piece is preferably a through hole. In particular, the at least one receptacle may be a stamped through hole which can be formed during stamp-bending of the thick conductor piece. In the alternative, the receptacle may be formed by other methods, such as drilling. Instead of a through hole, the at least one receptacle may also be formed as a blind hole.

In order to seal a contact between the thin conductor piece and the thick conductor piece, the at least one thick conductor piece, at least in the vicinity of the receptacle may be provided with a sealant and/or an adhesive. Just by way of example, the sealant and/or adhesive may be applied prior to inserting the press-fit element into the receptacle. Just by way of example, the sealant and/or adhesive may be applied around a rim of the receptacle prior to insertion. In the alternative or additionally, a sealant and/or adhesive may be applied where needed after insertion of the press-fit element. An adhesive may glue the thin conductor piece to the thick conductor piece, whereas a sealant may seal interfaces between the parts, in particular an interface between the conductor pieces or between the press-fit element and the conductor pieces.

The at least one protrusion of the thin conductor piece is preferably pre-shaped. In other words, the protrusion is preferably shaped prior to insertion into the receptacle. For connecting the conductor pieces, the at least one pre-shaped protrusion is inserted into the receptacle. Subsequently, the press-fit element is inserted into the receptacle. In the assembled state, the press-fit element may press the thin conductor piece against the inner wall of the receptacle, thereby establishing an electrical and mechanical connection between the two conductors.

The at least one protrusion preferably surrounds an insertion opening for the press-fit element. The insertion opening may be part arranged in the thin conductor piece.

The at least one protrusion preferably protrudes essentially perpendicular from a neighboring section of the thin conductor piece. The thin conductor piece may, at least in part, have an overall planar shape. From a plane of the thin conductor piece, the at least one protrusion extends essentially perpendicular to said plane.

Preferably, the at least one protrusion has the shape of a collar, in particular an overall circular shape. In this case, the protrusion may abut the inner wall of the receptacle along its whole circumference in the assembled state. Thereby, a large contact area between the two conductor pieces may be provided. The protrusion may in particular have an overall cylindrical shape. However, the at least one protrusion may also be provided with other shapes, such as a conical shape. A conical shape, which tapers in a direction away from the remaining thin conductor piece, may facilitate the insertion of the protrusion into the receptacle.

The at least one protrusion and the at least one receptacle preferably have geometrically similar cross-sections. The cross-sections refer to cross-sections perpendicular to an insertion direction or parallel with the plane of the thick conductor piece.

In other words, the protrusion and the receptacle may have a similar shape, but different sizes. If the receptacle has an overall circular shape, then the protrusion preferably also has a circular shape. If the receptacle has an overall polygonal shape, then the protrusion preferably also has a polygonal shape. The shape of the press-fit element preferably also resembles the shape of the protrusion and/or the receptacle.

The at least one protrusion with an overall circular shape is preferably formed continuously in the circumferential direction along the circular shape. In other words, the at least one protrusion is preferably formed as a tube which may have a cylindrical conical shape.

In the alternative, the at least one protrusion may be formed in a non-continuous manner. In the simplest case, the at least one protrusion may be formed as a strip which can be arranged between a press-fit element and the inner wall of the receptacle. In the alternative, the at least one protrusion may have a basically cylindrical shape, wherein the cylindrical shape is interrupted. In other words, the protrusion may comprise sections, each of which has a shape of a cylindrical section. Just by way of example, the protrusion may have an overall cylindrical shape which is provided with slits, interruptions or recesses which extend parallel to an insertion direction into the material of the protrusion. If, for example, the protrusion is provided with two such slits, and if these slits are arranged opposite to each other, then the protrusion is formed by two half-cylinders which are arranged opposite each other.

The at least one protrusion, in particular a protrusion with an overall circular shape, may be formed by stamping a hole into the thin conductor piece, in particular a round hole. Afterwards, the material in the close vicinity of the hole may be deep drawn or stretched such that material of the thin conductor piece forms the at least one protrusion. In the alternative, the at least one protrusion may be formed by drilling. However, stamping is preferred.

The at least one thin conductor piece may be a conducting part, in particular a conducting layer, of a flexible printed circuit (FPC) or of a flat flexible cable (FFC). In the alternative, the thin conductor piece may also be a sheet of conducting material. If, for example, the thin conductor piece is a layer of a FPC or another multilayered structure, then the at least one protrusion may also comprise at least one additional layer. If, for example, the thin conductor piece is a copper layer that is joined to at least one additional layer, such as a polyimide layer, then the at least one protrusion may be formed from both of these layers. Thereby, a processing step, in which the conducting layer that forms the thin conductor piece is separated from the at least one other layer, can be omitted. In the case of a multilayer structure, the at least one protrusion is formed such that the thin conductor piece forms the outer surface of the protrusion in order to contact the inner wall of the receptacle. The at least one other layer can be arranged between the thin conductor piece and the press-fit element in the assembled state.

The at least one protrusion may be tin plated prior to insertion into the receptacle in order to protect the material of the protrusion and to improve the electrical and/or mechanical connection with the thick conductor piece.

The thickness of the thin conductor piece adjacent to the at least one protrusion is preferably smaller than the thickness of the thick conductor piece adjacent to the at least one receptacle. In particular, the thin conductor piece may have a thickness measuring less then 100 µm, and preferably less than and 50 µm. The thickness of the thick conductor piece may be less than 3 mm, and preferably less than 1 mm.

The assembly may further comprise at least one bushing for being arranged between the at least one press-fit element and the at least one protrusion of the at least one thin conductor piece in the assembled state. The bushing may be inserted after the insertion of the protrusion into the receptacle. After insertion of the bushing, the press-fit element may be inserted into an insertion opening of the bushing. Damage to the thin conductor piece may thus be prevented during insertion of the press-fit element. This is particularly helpful when the thin conductor piece is made from a damageable material, The material may be thinner than 100 µm. However, this is not mandatory.

The bushing may be flexible such that a force exerted from the press-fit element can be applied onto the protrusion and onto the inner wall of the receptacle even if the bushing is present. In particular, the bushing may be made from metal such as steel with a thickness small enough to fulfill the bushing's function.

In order to improve the electrical contact between the thin conductor piece in the receptacle and the inner wall of the receptacle, the at least one bushing is preferably provided with at least one rib, the rib projecting from an outer side of the bushing towards the at least one protrusion, at least in the assembled state. In the assembled state, the force which presses the protrusion of the thin conductor piece against the inner wall of the receptacle is increased in the region of the rib since the bushing has an increased diameter in this region. Another advantage, in addition to the improved electrical contact, is that oxide layers on the inner wall of the receptacle, in particular when the thick conductor piece is made from aluminum, may be removed by friction between the rib and the inner wall of the receptacle.

The at least one rib is preferably arranged circumferentially around the bushing. The at least one bushing may be provided with one, two, three or more ribs. A plurality of ribs is preferably arranged such that the ribs are parallel with each other. The at least one rib is preferably formed continuously along the circumference of the bushing. In the alternative, a rib may also be interrupted or formed as a series of dots only.

As an alternative to a rib, the at least one bushing may be provided with at least one protrusion on its outer side. Just by way of example, the outer side of the bushing may be provided with a knob or a plurality of knobs. In the case of a plurality of knobs, these knobs are preferably spread around the outer surface of the bushing.

The at least one bushing is preferably shaped as a cylinder. In the alternative, the bushing may also have an overall conical shape in order to facilitate insertion into the receptacle. As a further alternative, the bushing may comprise slits which extend parallel to an axial direction of the bushing.

Alternatively to the bushing, other means which essentially fulfill the same function as the aforementioned bushing can be used. For example, at least two sliding members can be inserted into the receptacle after insertion of the protrusion. These sliding members may allow insertion of the press-fit element without damaging the protrusion since they may function as spacers. In the assembled state, the press-fit element may press against at least one of these sliding members, which in turn presses the protrusion against the inner wall of the receptacle. The sliding members may be formed as strips or rods. If two sliding members are present, these two sliding members are preferably arranged opposite one another across the receptacle in the assembled state. If more sliding members are provided, these members are preferably arranged equidistant to one another along the circumference of the receptacle.

In order to facilitate the insertion of a bushing and in order to protect the protrusion in the assembled state, the at least one bushing may be provided with at least one radial flange which is arranged adjacent to the at least one receptacle in the assembled state. Said flange preferably protrudes radially from the remaining bushing. The flange is preferably arranged coaxially with the remaining bushing and, if present, parallel with a rib of the bushing.

It should be noted that the connection assembly and the method according to the invention are particular advantageous for mass production of connections between a thin conductor piece and a thick conductor piece due to the press connection. In particular, 20 connections or more can be produced at the same time by a device being provided with a plurality of insertion tools for the press-fit elements. Consequently, a plurality of press-fit elements can be inserted into a plurality of receptacles with a single movement of a device.

In the following, the invention and its improvements are described in greater detail using exemplary embodiments and with reference to the figures. As described above, the various features shown in the embodiments may be used independently of one another in specific applications.

In the following figures, elements having the same function and/or the same structure will be referenced by the same reference signs.

In the drawings:
- Fig. 1: shows a connection assembly prior to the connection of the conductors and prior to insertion of the press-fit element;
- Fig. 2: shows the assembly of Fig. 1 in an assembled state of the press-fit element;
- Fig. 3: shows the protrusion of the assembly of Fig. 1 in a close-up view;
- Fig. 4: shows a second embodiment of a protrusion;
- Fig. 5: shows the assembly of Fig. 1 with an applied sealant;
- Fig. 6: shows a connection assembly according to an embodiment, comprising a bushing;
- Fig. 7: shows the bushing of the assembly in Fig. 6 in a close-up view; and
- Fig. 8: shows a second embodiment of a bushing.

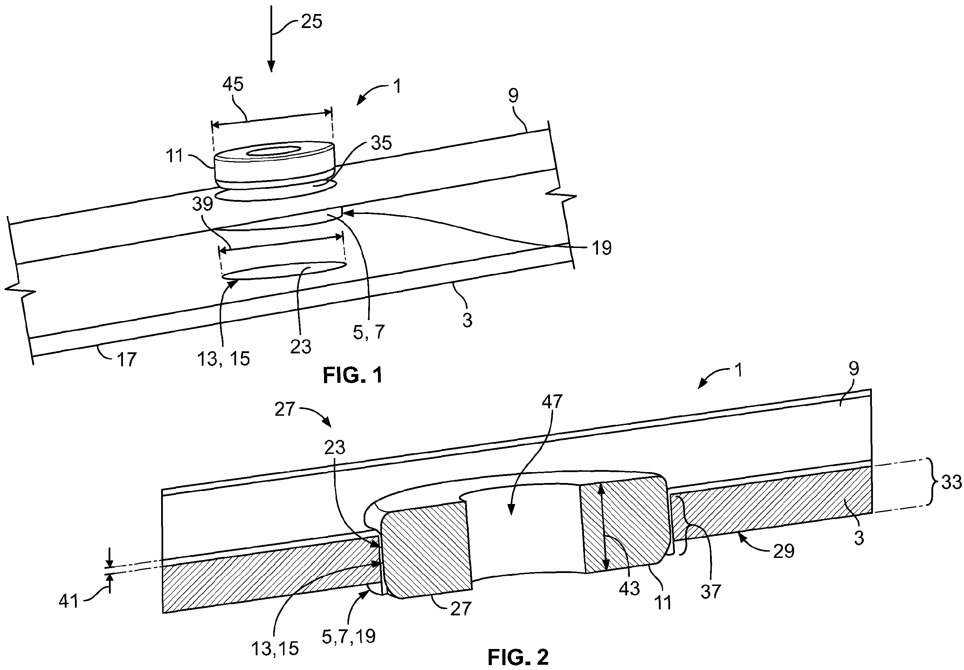

In the following, a first advantageous embodiment of a connection assembly 1 according to the invention is described with respect to Figs.1 to 3.

The connection assembly 1 comprises a thick conductor piece 3. The thick conductor piece 3 is preferably made from aluminum or an alloy containing mostly aluminum. The thick conductor piece 3 preferably has a plate-like shape. However, this is not mandatory. The thick conductor piece 3 is preferably part of a cell connector from a battery system.

The assembly 1 further comprises a thin conductor piece 5 intended for being connected with the thick conductor piece 3. The thin conductor piece 5 of the exemplary embodiment is a copper layer 7 of a flexible printed circuit (FPC) 9. In the alternative, the thin conductor piece may also be a conducting foil, a conducting metal sheet or a part of a flat flexible cable (FFC). The thin conductor piece 5 is preferably made from copper or an alloy containing mostly copper.

Finally, the assembly 1 also comprises a press-fit element 11.

The thick conductor piece 3 is provided with a through hole 13 that forms a receptacle 15 for receiving the press-fit element 11. The through hole 13 preferably has a circular cross-section and extends perpendicular to a plane 17 of the plate-like thick conductor piece 3 through the same.

The thin conductor piece 5 is provided with a protrusion 19. In an assembled state 21, which is shown in Fig. 2, the protrusion 19 is arranged between the press-fit element 11 and the inner wall 23 of the receptacle 15. The protrusion 19, which is a part of the thin conductor piece 5, is, in the assembled state 21, in electrical contact with the thick conductor piece 3. Due to a radial force exerted from the press-fit element 11 and from thick conductor piece 3 in a direction opposite to the force exerted from the press-fit element 11, the protrusion 19 is pressed against the inner wall 23 which is part of the thick conductor piece 3. The term radial force relates to a force exerted perpendicular to an insertion direction 25, which is the direction along which the press-fit element 11 is inserted into the receptacle 15. The radial force 27 is depicted with an arrow in Fig. 2.

In the assembled state 21, the conductor pieces 3 and 5 are arranged parallel with each other and, thereby, parallel with the plane 17 of the thick conductor piece 3 and preferably abut each other. The protrusion 19 may extend through the receptacle 15 and protrude from an underside 29 of the thick conductor piece 3. The term underside 29 refers to the side of the thick conductor piece 3 which is opposite the side on which the thin conductor piece 5 is arranged. Consequently, the protrusion 19 may have a length 31 which is larger than a thickness 33 of the thick conductor piece 3. Alternatively, the length 31 may be equal or smaller than the thickness 33. Thereby, the length 31 is measured along a direction parallel to insertion direction 25 and/or perpendicular to the plane 17 of the thick conductor piece 3. The protrusion 19 surrounds an insertion opening 35 for the press-fit element 11, the insertion opening 35 being arranged in the thin conductor piece 5.

The protrusion 19 has an overall circular cross-section perpendicular to the insertion direction 25. In the first embodiment, the protrusion has an overall cylindrical shape, wherein the axis of the cylinder is coaxial with the direction of insertion 25 in the assembled state 21.

The receptacle 15 is shaped geometrically similar to the protrusion 19 and therefore has an overall round shape. In the assembled state 21, the protrusion 19 preferably abuts the inner wall 23 of the receptacle 15 and is therefore in contact with the thick conductor piece 3 along the whole circumference of the protrusion 19.

The thin conductor piece 5 may be, at least at the protrusion 19, tin-plated in order to improve the electrical contact and/or to avoid sealing process between the conductor pieces 3 and 5.

The protrusion 19 extends essentially perpendicular to the remaining thin conductor piece 5, at least to the thin conductor piece 5 in the vicinity of the protrusion 19. Instead of a cylindrical shape, the protrusion 19 may have an overall conical shape in order to facilitate insertion into the receptacle 15.

A diameter 37 of the protrusion 19, measured perpendicular to the insertion direction 21, is preferably smaller than a diameter 39 of the receptacle 15. Thereby, insertion of the protrusion 19 into the receptacle 15 is facilitated. After insertion of the protrusion 19 into the receptacle 15, the radial force 27 exerted by the press-fit element 11 may stretch the material of the thin conductor piece 5 in the protrusion 19 such that the protrusion 19 abuts the inner wall 23.

The thickness 41 of the thin conductor piece 5 is preferably smaller than the thickness 33 of the thick conductor piece 3. Preferably, the thin conductor piece 3 is more flexible than the thick conductor piece 5.

According to the invention, press-fit element 11 has a shape of a disc, a ring or a pill. According to a preferred embodiment, the diameter 45 may be up to 10 mm. However, depending on the requirements, the diameter may also be larger.

In the case of a disc-shape, the thickness 43 of the press-fit element 11, measured along the insertion direction 25 in the assembled state 21, is preferably smaller than a diameter 45 of the press-fit element 11. Consequently, the disc-shaped press-fit element 11 is arranged parallel to the thick conductor piece 3 in the assembled state 21.

The press-fit element 11 has a geometrically similar cross-section to the protrusion 19 and the receptacle 15. In the first embodiment, the press-fit element 11 consequently has an overall circular shape for being inserted into the insertion opening 35 and the receptacle 15. The diameter 45 is preferably identical to or smaller than the diameter 39 of the receptacle. The diameter 45 is chosen such that a radial force may be exerted onto the protrusion 19 towards the inner wall 23 in the assembled state 21.

The press-fit element is preferably elastically compressible, at least in a direction parallel with its diameter 45. The press-fit element may be compressed during insertion such that it may press the protrusion 19 against the inner wall 23 of the receptacle 15.

In order to facilitate the compression of the press-fit element 11, the press-fit element 11 preferably has an overall shape of a ring. Consequently, the press-fit element 11 is provided with a through hole 47 in its center, the through hole 47 extending parallel with the direction of insertion 25. The through hole 47 may also be used for inserting a tool, which can be used for aligning the press-fit element 11 with the insertion opening 35, and for pressing the press-fit element into the receptacle 15.

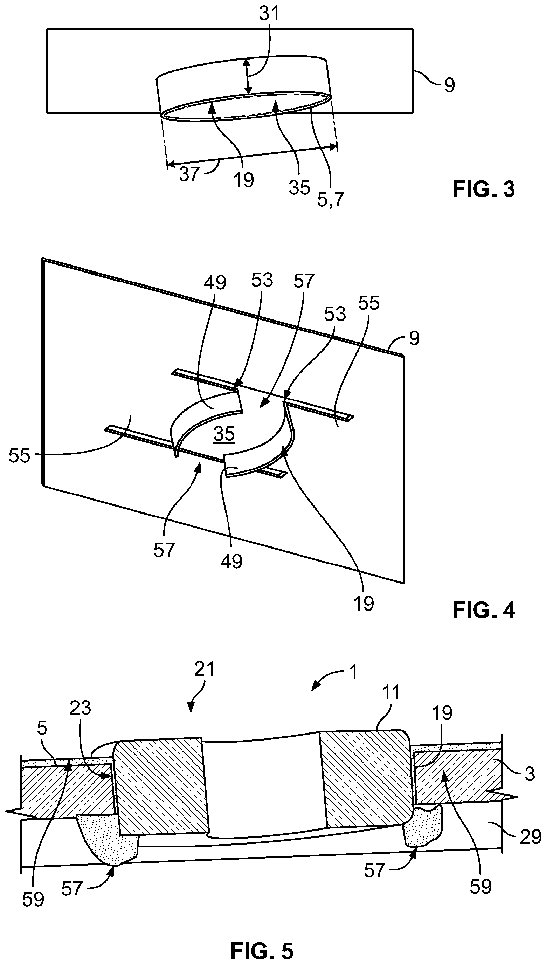

In Fig. 4, a second embodiment of a protrusion 19 is shown. The second embodiment of the protrusion 19 may also be used in an assembly 1 as described above.

In contrast to the first embodiment of a protrusion 19, which is shown in Fig. 3, the second embodiment is not provided with a continuous cylindrical shape along the circumference. Instead, the protrusion 19 is provided with parts of a cylindrical shape only. These two parts 49 are arranged opposite each other across the insertion opening 35. In other words, the protrusion 19 has an overall cylindrical shape which is interrupted by two interruptions 51 which are arranged opposite each other across the insertion direction 35.

It should be noted that the protrusion 19 may also be formed with a plurality of interruptions 51 and, consequently, with a plurality of parts 49. According to another alternative, the protrusion 19 may be formed by a single part 49 only. The two parts 49 are each seated on a free end 53 of a tongue 55. Each tongue 55 is elastically deflectable. Thereby, the parts 49 are provided with a movability which may facilitate the insertion of the protrusion 19 into the receptacle 15.

Alternatively, the second embodiment of the protrusion 19 may, instead of having an overall cylindrical shape, have an overall conical shape.

In the following, a further embodiment of the assembly 1 according to the invention is described with respect to Fig. 5. The assembly 1 itself may be formed according to the first embodiment as described above. The protrusion 19 may either be formed according to the embodiment of Fig. 3 or the embodiment of Fig. 5. The protrusion 19 may of course also be formed with any other appropriate shape.

The assembly 1 is provided with a sealant 57 for sealing the interface between the protrusion 19 and the press-fit element 11, and also the interface between the protrusion 19 and the inner wall 23. The sealant preferably extends circumferentially along the assembly 1, following the course of the protrusion 19.

The sealant may be applied to the underside 29 of the thick conductor piece 3. Additionally or in the alternative, the opposite side of the assembly 1 may also be provided with sealant 57 to seal the interface between the thin conductor piece 5 and the thick conductor piece 3. Said sealant 57 may be provided after the assembly 1 is in the assembled state 21.

Parts of the assembly may also be provided with an adhesive, in particular an adhesive sealant 59 in order to seal the contact area between thin conductor piece 5 and thick conductor piece 3 and to increase mechanical stability between the parts. In particular, the region around the receptacle 15 may be provided with adhesive sealant 59 prior to bringing the thick and thin conductor pieces 3 and 5 together and to seal the contact interface between conductor piece 5 und the conductor piece 3.

Also the inner wall 23 could be provided with adhesive sealant prior to insertion of the protrusion 19. It is clear to the person skilled in the art that the adhesive 59 could also be provided on the thin conductor piece 5 prior to insertion in order to achieve the same result.

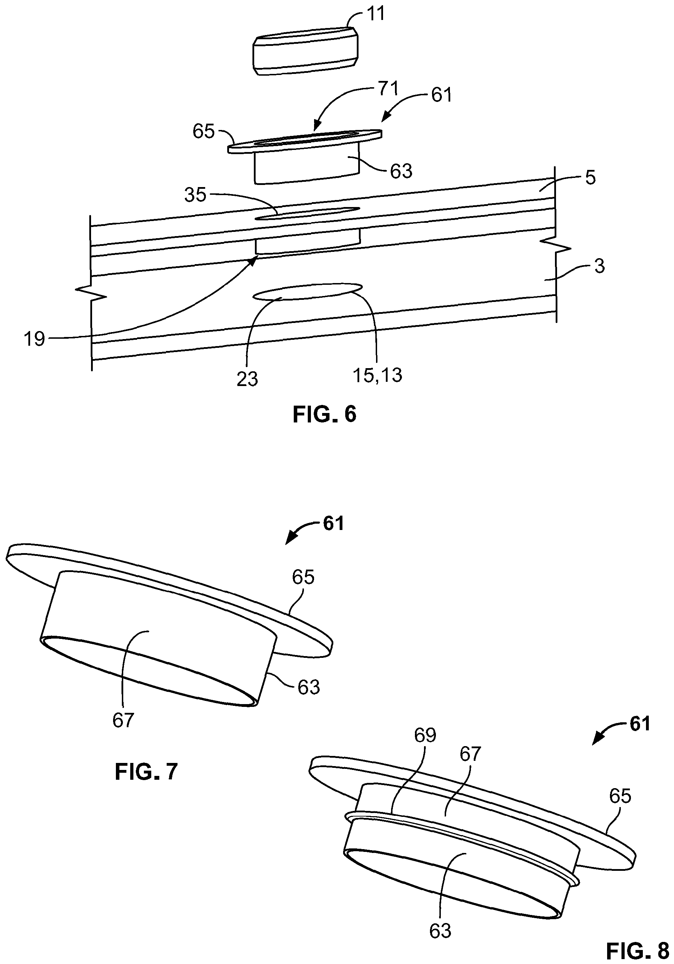

In the following, a further advantageous embodiment of the assembly 1 is described with respect to Figs. 6 to 8. Thereby, Fig. 6 shows the embodiment prior to assembling the assembly 1, and Figs. 7 and 8 show 2 different bushings 61 which can be used for the embodiment of Fig. 6. For the sake of brevity, only the differences with respect to the aforementioned embodiments are described.

The embodiment of Fig. 6 is provided with essentially similar parts as the aforementioned embodiments. However, an additional bushing 61 is provided which can be inserted into the receptacle 15 after the protrusion 19 has been inserted. Consequently, the bushing 61 extends into the insertion opening 35 of the thin conductor piece 5 in the assembled state 21.

The diameters of the insertion opening 35, the receptacle 15 and/or the press-fit element 11 are adapted accordingly in order to allow the press-fit element 11 to be inserted.

A cylindrical portion 63 of the bushing 61 is arranged between the press-fit element 11 and the protrusion 19 and, consequently, the inner wall 23 in the assembled state (not shown). The bushing 61 may protect the thin conductor piece 5, or at least the protrusion 19 of the same during insertion of the press-fit element 11.

The bushing 61 is preferably stretchable in order to allow a force exerted by the press-fit element 11 to press the protrusion 19 against the thick conductor piece 3. Preferably, the bushing 61 is provided with a flange portion 65 on one of its axial ends. The flange portion 65 may abut the thin conductor piece 5 in the assembled state, therefore protecting a transition region between the planar-shaped thin conductor piece 5 and the protrusion 19. The cylindrical portion 63 may be formed continuously along its circumference. However, said portion may also be provided with interruptions or slits as long as it is still capable of spacing the press-fit element 11 apart from the protrusion 19.

The cylindrical shape of the bushing 61 is not mandatory. It is preferable in the case that the other parts also have essentially circular cross-sections. If, however, the assembly 1 is provided with parts following a different shape, then the bushing, in particular the portion 63, may have a shape that differs from a cylindrical shape and follows the shape of the other parts.

The embodiment of the bushing 61 shown in Fig. 7 has an outer surface 67 which follows the cylindrical shape. The embodiment shown in Fig. 8 has an essentially similar surface 67 but is, additionally, provided with a circumferential rib 69 which extends circumferentially around the cylindrical portion 63.

The bushing 61 may be provided with one or more of the ribs 69. The ribs 69 may help to remove oxide layers from the inner wall 23 and therefore to improve the electrical contact between the conductor pieces 3 and 5, in particular, when at least one of the conductor pieces 3 and 5 is made from aluminum.

The flange 65 extends radially over the cylindrical portion 63 and opens up an insertion opening 71 at its center for insertion of the press-fit element 11.

### REFERENCE NUMERALS

- 1: connection assembly
- 3: thick conductor piece
- 5: thin conductor piece
- 7: conducting layer
- 9: flexible printed circuit
- 11: press-fit element
- 13: through hole
- 15: receptacle
- 17: plane of the thick conductor piece
- 19: protrusion
- 21: assembled state
- 23: inner wall
- 25: insertion direction
- 27: radial force
- 29: underside
- 31: length of the protrusion
- 33: thickness of the thick conductor piece
- 35: insertion opening
- 37: diameter of the protrusion
- 39: diameter of the receptacle
- 41: thickness of the thin conductor piece
- 43: thickness of the press-fit element
- 45: diameter of the press-fit element
- 47: through hole
- 49: parts
- 51: interruption
- 53: free end
- 55: tongue
- 57: sealant
- 59: adhesive sealant
- 61: bushing
- 63: cylindrical portion
- 65: flange
- 67: outer surface
- 69: rib
- 71: insertion opening

## Claims

1. Connection assembly (1) Z comprising at least one thin conductor piece (5) and a thick conductor piece (3) configured to be electrically connected to each other, the thick conductor piece (3) comprising at least one receptacle (15) having an inside wall, the at least one thin conductor piece (5) comprising at least one protrusion (19) for insertion into the receptacle (15), **characterized in that** the assembly (1) further comprises a press-fit element (11) adapted to be inserted into the receptacle (15) with the protrusion (19) being arranged in the receptacle (15) between the press-fit element (11) and the thick conductor piece (3), and **in that** the press-fit element (11) has a shape according to at least one of the following: disc-like, ring-like, pill-like.

2. Connection assembly (1) according to claim 1, wherein the at least one protrusion (19) at least partly surrounds an insertion opening (35) of the thin conductor piece (5) for inserting the press-fit element (11).

3. Connection assembly (1) according to any of claims 1 to 2, wherein, in an assembled state (21) of the assembly (1), a press-fit connection between the at least one protrusion (19) and the inner wall (23) is generated by the at least one press-fit element (11) and the thick conductor piece 3.

4. Connection assembly (1) according to any of claims 1 to 3, wherein the at least one receptacle (15) is a through hole (13).

5. Connection assembly (1) according to any of claims 1 to 4, wherein the thick conductor piece (3) is, at least in the vicinity of the at least one receptacle (15), provided with sealant (57) and/or adhesive sealant (59).

6. Connection assembly (1) according to any of claims 1 to 5, wherein the at least one protrusion (19) protrudes essentially perpendicular from a neighboring section of the thin conductor piece (5).

7. Connection assembly (1) according to any of claims 1 to 6, wherein the at least one protrusion (19) and the at least one receptacle (15) have geometrically similar cross-sections in a plane (17) of the thick conductor piece (3).

8. Connection assembly (1) according to any of claims 1 to 7, wherein the at least one thin conductor piece (5) is at least a part of a flexible printed circuit (9), of a flat flexible cable or of sheet-metal.

9. Connection assembly (1) according to any of claims 1 to 8, wherein a thickness (41) of the thin conductor piece (5) adjacent to the at least one protrusion (19) is smaller than a thickness (33) of the thick conductor piece (3) adjacent to the at least one receptacle (15).

10. Connection assembly (1) according to any of claims 1 to 9, wherein the assembly (1) further comprises at least one bushing (61) to be arranged between the at least one press-fit element (11) and the at least one protrusion (19) of the at least one thin conductor piece (5) in an assembled state (21).

11. Connection assembly (1) according to claim 10, wherein the at least one bushing (61) is provided with at least one rib (69) which projects from an outer side of the bushing (61) towards the at least one protrusion (19) in the assembled state (21).

12. Connection assembly (1) according to claim 10 or 11, wherein the at least one bushing (61) is provided with at least one radial flange (65) which is arranged adjacent to the at least one receptacle (15) in the assembled state (21).

13. Method for connecting at least one thin conductor piece (5) with a thick conductor piece (3), wherein at least one protrusion (19) of the at least one thin conductor piece (5) is inserted into at least one receptacle (15) in the thick conductor piece (3), **characterized in that**
at least one press-fit element (11) is inserted into the receptacle (15), pressing the at least one protrusion (19) against an inner wall (23) of the receptacle (15), and **in that**
the at least one press-fit element (11) has a shape according to at least one of the following: disc-like, ring-like, pill-like.

14. Method according to claim 13, wherein at least one bushing (61) is inserted into an insertion opening (35) of the thin conductor piece (5) and the press-fit element (11) is subsequently inserted into the bushing (61).

## Patentansprüche

1. Verbindungsanordnung (1), die wenigstens ein dünnes Leiterstück (5) sowie ein dickes Leiterstück (3) umfasst, die so ausgeführt sind, dass sie elektrisch miteinander verbunden werden,
das dicke Leiterstück (3) wenigstens eine Aufnahme (15) mit einer Innenwand umfasst, das wenigstens eine dünne Leiterstück (5) wenigstens einen Vorsprung (19) zur Einführung in die Aufnahme (15) umfasst,
**dadurch gekennzeichnet, dass**
die Anordnung (1) des Weiteren ein Presspassungs-Element (11) umfasst, das zum Einführen in die Aufnahme (15) eingerichtet ist, wobei der Vorsprung (19) in der Aufnahme (15) zwischen dem Presspassungs-Element (11) und dem dicken Leiterstück (3) angeordnet ist, und
das Presspassungs-Element (11) scheibenartig, ringartig oder/und pillenartig geformt ist.

2. Verbindungsanordnung (1) nach Anspruch 1, wobei der wenigstens eine Vorsprung (19) eine Einführungsöffnung (35) des dünnen Leiterstücks (5) zum Einführen des Presspassungs-Elementes (11) wenigstens teilweise umgibt.

3. Verbindungsanordnung (1) nach einem der Ansprüche 1 bis 2, wobei in einem montierten Zustand (21) der Baugruppe (1) durch das wenigstens eine Presspassungs-Element (11) und das dicke Leiterstück (3) eine Presspass-Verbindung zwischen dem wenigstens einen Vorsprung (19) und der Innenwand (23) erzeugt wird.

4. Verbindungsanordnung (1) nach einem der Ansprüche 1 bis 3, wobei die wenigstens eine Aufnahme (15) ein Durchgangsloch (13) ist.

5. Verbindungsanordnung (1) nach einem der Ansprüche 1 bis 4, wobei das dicke Leiterstück (3) wenigstens in der Nähe der wenigstens einen Aufnahme (15) mit Dichtungsmittel (57) und/oder klebendem Dichtungsmittel (59) versehen ist.

6. Verbindungsanordnung (1) nach einem der Ansprüche 1 bis 5, wobei der wenigstens eine Vorsprung (19) von einem benachbarten Teilabschnitt des dünnen Leiterstücks (5) aus im Wesentlichen senkrecht vorsteht.

7. Verbindungsanordnung (1) nach einem der Ansprüche 1 bis 6, wobei der wenigstens eine Vorsprung (19) und die wenigstens eine Aufnahme (15) geometrisch ähnliche Querschnitte in einer Ebene (17) des dicken Leiterstücks (3) haben.

8. Verbindungsanordnung (1) nach einem der Ansprüche 1 bis 7, wobei das wenigstens eine dünne Leiterstück (5) wenigstens ein Teil einer flexiblen Leiterplatte (9), eines flexiblen Flachkabels oder eines Blechs ist.

9. Verbindungsanordnung (1) nach einem der Ansprüche 1 bis 8, wobei eine Dicke (41) des dünnen Leiterstücks (5) an den wenigstens einen Vorsprung (19) angrenzend kleiner ist als eine Dicke (33) des dicken Leiterstücks (3) an die wenigstens eine Aufnahme (15) angrenzend.

10. Verbindungsanordnung (1) nach einem der Ansprüche 1 bis 9, wobei die Baugruppe (1) des Weiteren wenigstens eine Buchse (61) umfasst, die in einem montierten Zustand (21) zwischen dem wenigstens einen Presspassungs-Element (11) und dem wenigstens einen Vorsprung (19) des wenigstens einen dünnen Leiterstücks (5) angeordnet ist.

11. Verbindungsanordnung (1) nach Anspruch 10, wobei die wenigstens eine Buchse (61) mit wenigstens einer Rippe (69) versehen ist, die in dem montierten Zustand (21) von einer Außenseite der Buchse (61) in Richtung des wenigstens einen Vorsprungs (19) vorsteht.

12. Verbindungsanordnung (1) nach Anspruch 10 oder 11, wobei die wenigstens eine Buchse (61) mit wenigstens einem radialen Flansch (65) versehen ist, der in dem montierten Zustand (21) an die wenigstens eine Aufnahme (15) angrenzend angeordnet ist.

13. Verfahren zum Verbinden wenigstens eines dünnen Leiterstücks (5) mit einem dicken Leiterstück (3), wobei wenigstens ein Vorsprung (19) des wenigstens einen dünnen Leiterstücks (5) in wenigstens eine Aufnahme (15) in dem dicken Leiterstück (3) eingeführt wird,
**dadurch gekennzeichnet, dass**
wenigstens ein Presspassungs-Element (11) in die Aufnahme (15) eingeführt und dabei der wenigstens eine Vorsprung (19) an eine Innenwand (23) der Aufnahme (15) gedrückt wird, und
das wenigstens eine Presspassungs-Element (11) scheibenartig, ringartig oder/und pillenartig geformt ist.

14. Verfahren nach Anspruch 13, wobei wenigstens eine Buchse (61) in eine Einführungsöffnung (35) des dünnen Leiterstücks (5) eingeführt wird und anschließend das Presspassungs-Element (11) in die Buchse (61) eingeführt wird.

## Revendications

1. Ensemble de connexion (1) comprenant au moins un élément conducteur mince (5) et un élément conducteur épais (3) configurés pour être connectés électriquement entre eux,
l'élément conducteur épais (3) comprenant au moins un réceptacle (15) comportant une paroi interne,
ledit au moins un élément conducteur mince (5) comprenant au moins une protubérance (19) à insérer dans le réceptacle (15),
**caractérisé en ce que** l'ensemble (1) comprend en outre un élément serti (11) adapté pour être inséré dans le réceptacle (15), la protubérance (19) étant agencée dans le réceptacle (15) entre l'élément serti (11) et l'élément conducteur épais (3),
et **en ce que** l'élément serti (11) présente une forme d'au moins l'un des types suivants : discoïdal, annulaire, sphéroïde.

2. Ensemble de connexion (1) selon la revendication 1, dans lequel ladite au moins une protubérance (19) entoure au moins partiellement une ouverture d'insertion (35) de l'élément conducteur mince (5) pour insérer l'élément serti (11) .

3. Ensemble de connexion (1) selon l'une quelconque des revendications 1 et 2, dans lequel, à l'état assemblé (21) de l'ensemble (1), une connexion sertie entre ladite au moins une protubérance (19) et la paroi interne (23) est générée par ledit au moins un élément serti (11) et l'élément conducteur épais (3).

4. Ensemble de connexion (1) selon l'une quelconque des revendications 1 à 3, dans lequel ledit au moins un réceptacle (15) est un trou traversant (13).

5. Ensemble de connexion (1) selon l'une quelconque des revendications 1 à 4, dans lequel l'élément conducteur épais (3) est pourvu, au moins à proximité dudit au moins un réceptacle (15), d'un mastic (57) et/ou d'un enduit adhésif (59).

6. Ensemble de connexion (1) selon l'une quelconque des revendications 1 à 5, dans lequel ladite au moins une protubérance (19) ressort de manière essentiellement perpendiculaire d'une section voisine de l'élément conducteur mince (5).

7. Ensemble de connexion (1) selon l'une quelconque des revendications 1 à 6, dans lequel ladite au moins une protubérance (19) et ledit au moins un réceptacle (15) ont des sections transversales géométriquement similaires dans un plan (17) de l'élément conducteur épais (3).

8. Ensemble de connexion (1) selon l'une quelconque des revendications 1 à 7, dans lequel ledit au moins un élément conducteur mince (5) est au moins une partie d'un circuit imprimé flexible (9), d'un câble flexible plat ou d'une tôle.

9. Ensemble de connexion (1) selon l'une quelconque des revendications 1 à 8, dans lequel l'épaisseur (41) de l'élément conducteur mince (5) adjacent à ladite au moins une protubérance (19) est inférieure à l'épaisseur (33) de l'élément conducteur épais (3) adjacent audit au moins un réceptacle (15).

10. Ensemble de connexion (1) selon l'une quelconque des revendications 1 à 9, dans lequel l'ensemble (1) comprend en outre au moins une bague (61) à agencer entre ledit au moins un élément serti (11) et ladite au moins une protubérance (19) dudit au moins un élément conducteur mince (5) à l'état assemblé (21).

11. Ensemble de connexion (1) selon la revendication 10, dans lequel ladite au moins une bague (61) est pourvue d'au moins une nervure (69) qui se projette depuis un côté externe de la bague (61) vers ladite au moins une protubérance (19) à l'état assemblé (21).

12. Ensemble de connexion (1) selon la revendication 10 ou 11, dans lequel ladite au moins une bague (61) est pourvue d'au moins une bride radiale (65) qui est agencée de manière adjacente audit au moins un réceptacle (15) à l'état assemblé (21).

13. Procédé de connexion d'au moins un élément conducteur mince (5) avec un élément conducteur épais (3), dans lequel au moins une protubérance (19) dudit au moins un élément conducteur mince (5) est insérée dans au moins un réceptacle (15) dans l'élément conducteur épais (3),
**caractérisé en ce qu'**au moins un élément serti (11) est inséré dans le réceptacle (15) en poussant ladite au moins une protubérance (19) contre une paroi interne (23) du réceptacle (15),
et **en ce que** ledit au moins un élément serti (11) présente une forme d'au moins l'un des types suivants : discoïdal, annulaire, sphéroïde.

14. Procédé selon la revendication 13, dans lequel au moins une bague (61) est insérée dans une ouverture d'insertion (35) de l'élément conducteur mince (5) et l'élément serti (11) est ensuite inséré dans la bague (61).
